Europäisches Patentamt

European Patent Office

Office européen des brevets

(19)

(11) EP 0 807 982 A1

(12) DEMANDE DE BREVET EUROPEEN

(43) Date de publication:
19.11.1997 Bulletin 1997/47

(51) Int Cl.6: H01L 31/0232, H01L 31/09

(21) Numéro de dépôt: 97401054.8

(22) Date de dépôt: 12.05.1997

(84) Etats contractants désignés:
DE FR GB

(30) Priorité: 13.05.1996 FR 9605899

(71) Demandeur: COMMISSARIAT A L'ENERGIE ATOMIQUE
75015 Paris (FR)

(72) Inventeurs:
• Gidon, Serge
38140 La Murette (FR)

• Destefanis, Gérard
38120 Saint-Egreve (FR)
• Bouchut, Philippe
38120 Saint-Egreve (FR)
• Peuzin, Jean-Claude
38320 Herbeys (FR)

(74) Mandataire: Moutard, Pascal Jean
c/o Brevatome,
25, rue de Ponthieu
75008 Paris (FR)

(54) **Photodétecteur à structure optique résonnante avec un réseau**

(57) L'invention a pour objet un dispositif de détection d'un rayonnement électromagnétique (3), comportant :

- une couche (4) de matériau photodétecteur, à gap direct, comportant une première face et une deuxiè-me face,
- un réseau (6) formé sur la deuxième face de la couche de matériau photodétecteur.

L'invention a également pour objet un détecteur bispectral.

FIG. 1

EP 0 807 982 A1

## Description

Domaine technique et art antérieur

L'invention concerne le domaine des détecteurs de rayonnement électromagnétique, par exemple des détecteurs infrarouges.

De manière plus précise, l'invention concerne le domaine des détecteurs quantiques de rayonnement, à gap direct.

Les détecteurs quantiques de rayonnement à gap direct (photodiodes) fonctionnent sur le principe de la création de paires électrons-trous au sein d'un matériau semi-conducteur. Les paires électrons-trous sont séparées par le champ électrique interne de la diode, réalisé dans le matériau par des zones de dopage différent. La détection d'un photon incident n'est possible que si l'énergie de celui-ci est supérieure à celle du processus de créations de paires (énergie de "gap", ou saut d'énergie entre la bande de valence et la bande de conduction). Ainsi, pour détecter un rayonnement IR (infrarouge, photons de faible énergie) on utilise des semi-conducteurs à petit gap. On choisit généralement le matériau ou sa composition, afin que son gap soit adapté au domaine de longueur d'onde. En particulier, un matériau de composition $H_{g1-x}Cd_xTe$ est particulièrement bien adapté à la détection de rayonnements infrarouges. On ne peut cependant pas choisir un matériau ayant un gap aussi petit que possible, car l'énergie d'activation thermique induit un courant dans la jonction, en l'absence de photons. Ce courant, dit courant d'obscurité, est source de bruits dans le détecteur. Il peut être réduit en refroidissant le détecteur (par exemple à la température de l'azote liquide : 77 K), mais ceci en complique l'utilisation.

Pour un matériau donné, et pour une température donnée, le courant d'obscurité est également directement lié à l'épaisseur de la zone active, alors que le courant photonique est, lui, une fonction asymptotique de l'épaisseur. La limitation asymptotique correspond à une absorption complète de l'onde. Il existe donc une épaisseur de matériau absorbant qui optimise le rapport signal/bruit. En général, cette épaisseur est de l'ordre de la longueur d'onde du rayonnement à détecter. Ainsi, dans le cas d'une détection infrarouge à 10 µm, l'épaisseur optimum se situe à environ 10 µm.

Exposé de l'invention

L'invention propose une structure pour un dispositif de détection de rayonnement électromagnétique, à base de matériau photodétecteur à gap direct, cette structure permettant une réduction de l'épaisseur de la zone active, et ceci afin de réduire le bruit du dispositif.

A cette fin, l'invention a pour objet un dispositif de détection d'un rayonnement électromagnétique comportant :

- une couche de matériau photodétecteur, à gap direct, comportant une première face et une deuxième face, et formant un guide optique,
- un réseau formé sur une des deux faces de la couche de matériau photodétecteur.

Dans cette structure, le réseau constitue, avec le guide optique formé par la couche de matériau photodétecteur, une structure résonnante.

Le réseau force l'onde électromagnétique à être diffractée dans le plan formé par la couche de matériau photodétecteur. Ainsi, l'épaisseur de cette dernière couche peut être réduite.

Il en résulte que le courant d'obscurité du détecteur est réduit, sans perte de signal utile.

Le rôle du réseau est de convertir le rayonnement incident en un mode électromagnétique en ondes stationnaires guidées, de très forte amplitude, qui est détecté par la couche photodétectrice.

De plus, la structure d'un détecteur selon l'invention ne nécessite pas de mettre en oeuvre un procédé d'élaboration des diodes très différent des procédés classiques. Seul un niveau de technologie supplémentaire (celui du réseau) doit être adapté dans le processus.

La solution proposée par la présente invention peut être appliquée à des détecteurs infrarouges dans la gamme de longueurs d'ondes comprises entre 2 et 20 µm, notamment entre 2 et 14 µm.

Le dispositif peut également comporter un substrat, transparent à une certaine longueur d'onde, la première face de la couche de matériau photodétecteur étant en contact avec ce substrat, le réseau étant formé sur la deuxième face de la couche de matériau photodétecteur.

Une couche intermédiaire peut être présente entre le réseau et la couche de matériau détecteur, du type couche d'adaptation d'impédance.

Le réseau peut être un réseau non conducteur.

Il peut aussi être conducteur. Dans un tel cas, il peut remplir, en plus de son rôle optique, un rôle de prise de contact de la diode. En particulier, des traits du réseau peuvent être en contact avec des zones de contact électrique implantées dans la couche de matériau photodétecteur.

En outre, des contacts électriques peuvent alors être établis entre le réseau et un circuit de lecture.

L'invention a également pour objet un dispositif de détection d'un rayonnement électromagnétique, comportant, dans cet ordre :

- une première couche, d'un premier matériau photodétecteur, d'épaisseur $e_1$,
- une couche intermédiaire d'un matériau transparent à deux longueurs d'onde harmoniques $\lambda$ et $n\lambda$,
- une seconde couche, d'un second matériau photodétecteur, d'épaisseur $e_2$,
- un réseau constituant, avec la première couche de premier matériau photodétecteur, une structure résonnante à la longueur d'onde nλ et, avec la seconde couche de second matériau photodétecteur et avec la couche intermédiaire de matériau transparent, une structure résonnante à la longueur d'onde λ.

Ce dispositif fonctionne sur des principes équivalents à ceux exposés ci-dessus pour le premier dispositif. En particulier, dans cette seconde structure, le réseau constitue, avec les deux guides optiques formés avec chaque couche de matériau photodétecteur et la couche intermédiaire de matériau transparent, une structure résonnante, à la longueur d'onde λ ou nλ. Le réseau force l'onde électromagnétique à être diffractée, suivant sa longueur d'onde, dans l'un ou l'autre des plans formés par les deux couches de matériau photodétecteur. Là encore, les épaisseurs de ces couches ne sont plus un paramètre déterminant, elles peuvent être réduites, et il en résulte un courant d'obscurité réduit, sans perte de signal utile.

Dans ce second mode de réalisation, chaque couche de matériau photodétecteur peut être relié à un circuit de lecture.

De plus, un substrat, transparent au moins aux deux longueurs d'onde λ et nλ peut être présent. Le dispositif comporte alors, dans cet ordre : le substrat transparent à λ et à nλ, la première couche de premier matériau photodétecteur (épaisseur $e_1$), la couche intermédiaire de matériau transparent à λ et nλ, la seconde couche de matériau photodétecteur (épaisseur $e_2$), et enfin le réseau.

Dans tous les cas, le réseau peut être un réseau à une ou à deux dimensions. Dans le cas d'un réseau à une dimension, le détecteur est sensible à l'état de polarisation de la lumière. Dans le cas d'un réseau à deux dimensions, il est quasiment insensible à l'état de polarisation de la lumière à détecter.

De même, dans tous les cas, le réseau peut comporter une première zone dans laquelle il présente un pas p, et au moins une seconde zone dans laquelle il présente un pas $p' = \frac{p}{2}$. On obtient ainsi une structure de détecteur, dite à réseau à pas harmonique. Une telle structure permet de réaliser un confinement latéral des rayonnements détectés dans les zones de pas p et $\frac{p}{2}$.

Un confinement latéral peut être également obtenu avec un réseau comportant au moins une zone dans laquelle son pas est à rapport cyclique variable. Lorsque cette variation se produit depuis le centre (rapport cyclique symétrique) jusqu'au bord d'une diode (rapport cyclique dissymétrique), on arrive à confiner l'onde détectée dans ladite diode.

Enfin, on peut également avoir un réseau présentant un rapport ℓ/p fixe (rapport cyclique), pouvant être tel que ℓ/p≠1/2 : on a ainsi un réseau à forme dissymétrique.

Brève description des figures

De toute façon, les caractéristiques et avantages de l'invention apparaîtront mieux à la lumière de la description qui va suivre. Cette description porte sur les exemples de réalisation, donnés à titre explicatif et non limitatif, en se référant à des dessins annexés sur lesquels :

- la figure 1 est une représentation schématique d'un premier mode de réalisation de l'invention,
- les figures 2A et 2B illustrent une structure selon l'invention, avec prise de contact dans la zone n, de manière répartie par l'intermédiaire du réseau,
- la figure 3 donne les réponses spectrales typiques d'un guide optique absorbant en résonance avec un réseau, en mode TE et TM,
- la figure 4 représente schématiquement une structure de détecteur selon l'invention, avec réseau à pas harmonique,
- la figure 5 représente schématiquement une structure de détecteur selon l'invention, avec réseau à rapport cyclique variable,
- la figure 6 est un autre exemple de réseau, avec $\ell / p \neq \frac{1}{2}$,
- la figure 7 (parties A et B) illustre schématiquement la structure et le fonctionnement d'un détecteur bispectral, avec réseau.

Description détaillée de modes de réalisation de l'invention

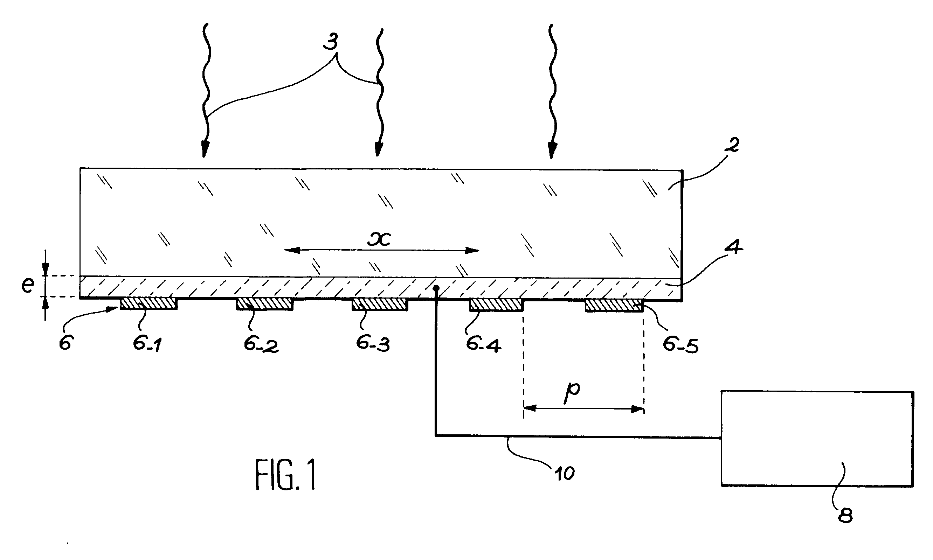

Un premier mode de réalisation de l'invention va être décrit en liaison avec la figure 1. Sur cette figure, la référence 2 désigne un substrat en un matériau transparent à au moins une longueur d'onde d'un rayonnement 3 à détecter. Ce substrat peut être par exemple un substrat en CdTe. Le rayonnement 3 traverse le substrat 2 et atteint une couche 4 détectrice. Cette couche peut être par exemple une couche en CdHgTe déposée sur le substrat 2. D'une manière générale, cette couche est constituée d'un matériau photodétecteur, à gap direct. Cette couche 4 est en fait comprise entre le substrat 2 et un réseau 6. Sur la figure 1, est représentée la trace des traits 6-1, 6-2,..., 6-5 d'un réseau 6, ces traits étant orientés suivant une direction perpendiculaire au plan de la figure. La structure représentée est donc une structure de réseau à une dimension.

Le pas p du réseau est choisi en fonction de la longueur d'onde du rayonnement 3 à détecter. En fait, le réseau 6 fonctionne, suivant les lois de la diffraction, les directions de la lumière diffractée étant fonction de la longueur d'onde, mais aussi du pas p du réseau.

Par conséquent, si une longueur d'onde λ donnée est à détecter, on choisira de préférence le pas p pour lequel l'onde incidente est susceptible d'être diffractée perpendiculairement à sa direction d'incidence, c'est-à-dire dans le plan du réseau (ou suivant la direction x de la figure 1). Pratiquement, ce pas p est sensiblement égal à la longueur d'onde du rayonnement dans le matériau 4, soit encore à λ/n, ou λ est la longueur d'onde du rayonnement dans le vide, et où n est l'indice de la structure essentiellement constituée par la couche 4 de matériau détecteur.

Réciproquement, pour un pas p donné du réseau, la longueur d'onde $\lambda_0$ détectée sera celle pour laquelle $\lambda_0 \simeq np$, où n a la même signification que ci-dessus. C'est pour cette longueur d'onde $\lambda_0$ que l'onde incidente est susceptible d'être diffractée perpendiculairement à cette direction d'incidence, dans le plan du réseau ou de la couche détectrice 4.

De même, chaque réseau a de préférence une certaine épaisseur optimum pour une longueur d'onde donnée : cette épaisseur optimum correspond à l'épaisseur à atteindre pour obtenir des interférences constructives entre le rayonnement réfléchi par la surface des traits du réseau située du côté de la couche de matériau détecteur, et l'autre surface, située du côté opposé à la couche de détecteur. Pratiquement, pour une longueur d'onde λ donnée, l'épaisseur optimum est de l'ordre de λ/4n, n étant l'indice de diffraction.

En fait, la structure constituée par le réseau 6 et le guide optique formé par le matériau absorbant 4 sur le substrat 2 est une structure résonnante à une certaine longueur d'onde. Le milieu voisin du réseau 6 étant absorbant, l'onde y est détectée. L'onde initiale se propage dans une direction perpendiculaire à la couche de matériau détecteur 4, et le réseau permet de modifier la direction de propagation k de l'onde à détecter : ce vecteur k se retrouve orienté suivant une direction comprise dans le plan de la couche détectrice 4. Ceci explique que, avec une structure telle que celle qui vient d'être décrite ci-dessus, l'épaisseur e de la couche de matériau détecteur 4 être réduite, tout en ne perdant pas de signal utile. La réduction d'épaisseur a pour conséquence une réduction du courant d'obscurité. Ainsi, pour une longueur d'onde incidente d'environ 10 μm, la structure de détecteur selon l'invention permet de travailler avec une couche de matériau détecteur 4 dont l'épaisseur est comprise entre environ 0,1 μm et 3 μm (par exemple : 0,5 μm, 1 μm ou 2 μm), tandis que les détecteurs selon l'art antérieur nécessitent une couche de matériau photodétecteur de l'ordre de 10 μm.

L'épaisseur de la couche de matériau détecteur 4 ne peut cependant pas être indéfiniment réduite. Du fait de la structure dissymétrique du guide obtenu (le réseau se trouve d'un seul côté du guide formé par la couche de détecteur et le substrat, et il y a absence de symétrie au sens de l'empilement des couches), le guide présente une épaisseur de coupure, en-dessous de laquelle le détecteur ne fonctionne plus très bien : l'onde, qui aurait dû se propager dans le guide absorbant (et détecteur), part dans le substrat et n'est pas "vue", donc pas détectée. Cette épaisseur de coupure varie avec la longueur d'onde : elle est de l'ordre de 0,5 μm pour une longueur d'onde, dans le vide, de 10 μm, et elle est de l'ordre de

0,25 μm pour une longueur d'onde, dans le vide, de 5 μm. Compte tenu de ces deux indications, l'homme du métier saura, pour chaque longueur d'onde incidente, trouver l'épaisseur de coupure e correspondante. Plus la longueur d'onde à détecter est élevée, plus l'épaisseur de coupure est élevée. En présence d'une couche de matériau détecteur d'indice $n_1$ et d'un substrat d'indice $n_2$ ($n_1 > n_2$), l'épaisseur de coupure dépend des indices $n_1$ et $n_2$.

Afin de réaliser un détecteur complet, la couche de matériau détecteur 4 est connectée à un circuit de détection. Pour un détecteur unique, tel que celui représenté sur la figure 1, il est possible de relier simplement la couche de matériau détecteur 4 à un circuit de lecture 8 par l'intermédiaire de connexions 10.

Cette solution n'est pas très commode pour un réseau de photodiodes, ou matrice de détecteurs.

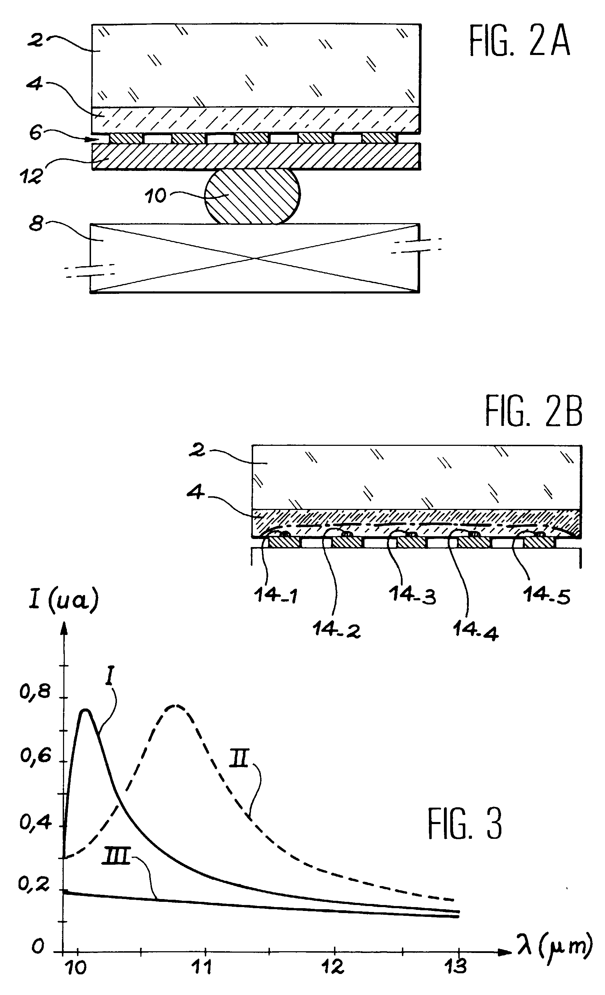

Dans ce dernier cas, il est alors préférable d'utiliser un réseau 6 métallique pouvant assurer, en plus de sa fonction optique, une fonction de prise de contact de la diode. Cette solution est illustrée sur la figure 2A, où les traits métalliques du réseau 6 sont reliés par un élément conducteur 12. Ce dernier est lui-même en contact avec une microbille 10, par exemple en indium, qui assure la jonction avec un circuit de lecture 8 en silicium. La connexion détecteur-circuit de lecture avec des microbilles est décrite par exemple dans l'article de G.L. Destefanis intitulé "HgCdTe infrared diode arrays" paru dans "Semiconductor Science and Technology", volume 6, pages C88-C92, 1991.

Afin d'assurer le contact entre les traits métalliques du réseau 6 et le matériau détecteur 4, il est possible de réaliser, comme illustré sur la figure 2B, des zones de contact 14-1, 14-2, , 14-5 par implantation localisée d'ions dans le matériau détecteur 4. Ces zones de contact permettent de former un contact électrique des traits métalliques du réseau, avec le matériau détecteur (on réalise un contact ohmique).

Une étude théorique de la structure décrite ci-dessus montre qu'on peut atteindre une efficacité de réseau de 74% (efficacité p=énergie couplée dans le guide/ énergie incidente), et ceci quelle que soit l'épaisseur de la couche absorbante, dans la limite de l'existence d'une onde guidée dans la structure. L'épaisseur de la couche absorbante influence le taux de perte de la structure, ces pertes contribuant à l'amortissement de la résonance et modifiant donc la réponse spectrale du détecteur. Plus la couche est fine, plus les pertes "effectives" de guide sont faibles. Plus l'amortissement est faible, plus la résonance est marquée, d'où une réponse spectrale pointue. La figure 3 montre une réponse spectrale typique calculée pour un guide ayant une couche de matériau détecteur 4 de 1,5 μm d'épaisseur, en CdHgTe, sensible à une longueur d'onde de 10 μm, le réseau ayant un pas de 3,6 μm et une épaisseur des traits de l'ordre de 0,4 μm. La courbe I donne la réponse spectrale pour une onde TE (direction du champ électrique $\vec{E}$ perpendiculaire aux traits du réseau), la courbe II donne une réponse spectrale en onde TM (direction du champ magnétique $\vec{B}$ perpendiculaire aux traits du réseau), et la courbe III donne la réponse spectrale sans réseau. Ces courbes font clairement apparaître l'influence du réseau. Elles montrent également, pour le cas du détecteur avec réseau, le phénomène de résonance obtenu autour d'une certaine longueur d'onde (environ 10 µm pour la courbe I et environ 10,7 µm pour la courbe II).

Le détecteur décrit ci-dessus est muni d'un réseau à une dimension, qui présente une symétrie de translation. Or, deux polarisations des ondes électromagnétiques sont identifiables : ce sont les polarisations dites TE et TM. Ces polarisations résonnent à des longueurs d'onde différentes, comme illustré ci-dessus par les courbes I et II de la figure 3. Par conséquent, dans le cas d'un réseau à une dimension, le détecteur est sensible à l'état de polarisation de la lumière. Cependant, il est également possible de réaliser un détecteur insensible à l'état de polarisation de la lumière. Pour cela, il faut réaliser un réseau à deux dimensions. De tels réseaux à deux dimensions sont réalisables avec diverses géométries de motifs périodiques aux formes quelconques (ronds, carrés, losanges, ...), plus ou moins intéressante suivant la réponse spectrale désirée.

Les diodes couramment utilisées ont des dimensions typiques maximales de l'ordre d'environ 30 µm. Ces diodes sont en général utilisées dans une matrice de diodes, à une ou à deux dimensions. Par ailleurs, l'efficacité d'un réseau est fonction du nombre de traits du réseau impliqué dans le processus de diffraction et de résonance optique. Compte tenu des dimensions typiques des diodes, qui sont, comme on l'a dit ci-dessus, assez faibles, et du pas du réseau, qui est en général de l'ordre de quelques µm, le nombre de traits par diode est restreint, le plus souvent de l'ordre d'une dizaine. L'efficacité pratique du réseau ne peut donc égaler celle d'un réseau "infini". Cependant, des configurations spécifiques, qui vont maintenant être décrites, en améliorent les performances. Ces configurations vont être décrites en géométrie monodimensionnelle, mais elles sont aisément transposables à une structure bidimensionnelle.

Ces configurations permettent, pour chaque détecteur, ou diode, individuel, d'y confiner le rayonnement qui y est détecté.

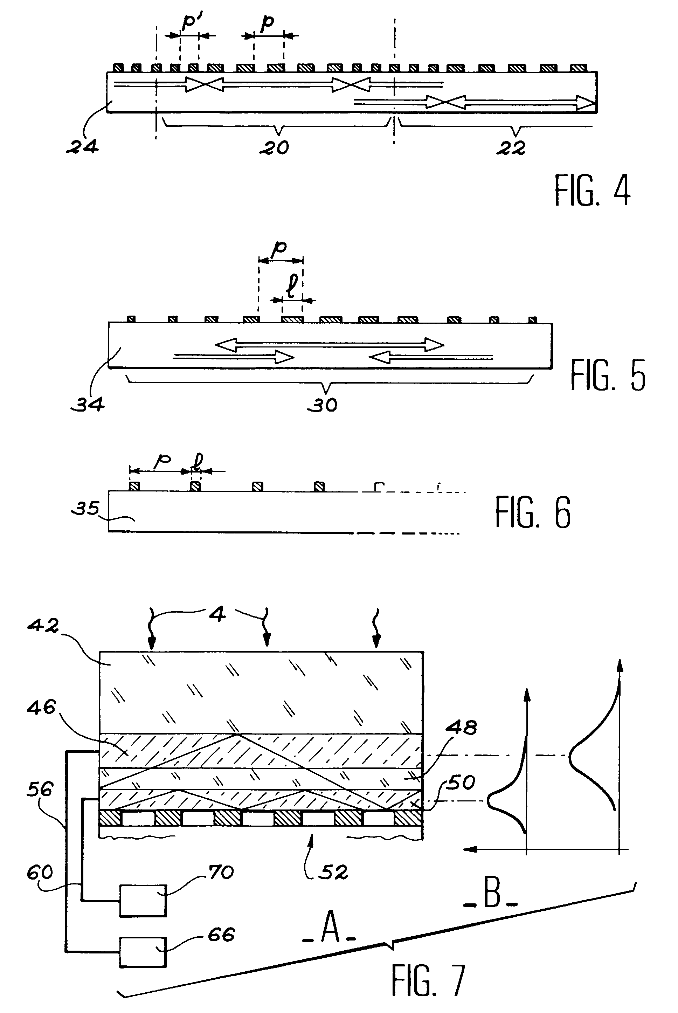

Une première variante de ce mode de réalisation est illustré sur la figure 4. Les références 20 et 22 y désignent respectivement des zones d'un premier et d'un second détecteurs. Ces deux détecteurs présentent une couche de matériau de détection 24 commune. Le substrat transparent sur lequel repose cette couche n'est pas représenté sur la figure 4. Le premier détecteur 20 est muni d'un réseau ayant un pas p dans la partie centrale et un pas p'=p/2 dans les parties latérales. Or, si l'onde électromagnétique est guidée sous le réseau quand celui-ci est de pas p sensiblement égal à $\lambda/n$ (où n est l'indice du guide), elle est au contraire réfléchie quand le pas du réseau devient égal à p/2. Ainsi, il est possible, pour chaque zone de détecteur individuel 20, de confiner le rayonnement détecté à l'intérieur même du détecteur 20. Il en résulte également que le rayonnement détecté par chaque détecteur individuel ne se propage pas dans les détecteurs voisins. Le confinement obtenu de l'onde électromagnétique, sous chaque pixel de détection, est un confinement à la fois longitudinal et transverse. Ainsi, la résonance du réseau est améliorée.

Une seconde variante de ce mode de réalisation va être décrite en liaison avec la figure 5, où la référence 34 désigne la couche de matériau détecteur, le substrat n'étant pas représenté. Soit 1 la largeur de chaque trait du réseau. A la surface du matériau détecteur 34, les traits du réseau définissent des "marches". Les "marches" du réseau sont symétriques lorsque la largeur du trait est sensiblement égal à la moitié du pas p du réseau. Dans ce cas, l'onde est indifféremment couplée dans les deux directions opposées, perpendiculaires aux traits du réseau. Par contre, si le profil du réseau n'est plus symétrique, c'est-à-dire si le rapport $\ell/p$ n'est plus constant et égal à 1/2, une direction de couplage de l'onde se trouve favorisée, (celle dirigée vers le pas de réseau symétrique). Ainsi, dans le cas de la figure 5, le rapport $\ell/p$ est variable, du centre de la diode 30 vers ses bords. Le rapport $\ell/p$ peut par exemple évoluer de manière périodique, avec une période spatiale T sensiblement égale à la largeur du détecteur 30. Il en résulte un confinement de l'onde détectée à l'intérieur de chaque pixel 30.

Une troisième variante, à forme dissymétrique du réseau ($\ell/p \neq \frac{1}{2}$, figure 6) permet un confinement localisé de l'onde sous chaque zone du réseau. Sur la figure 6, le matériau détecteur est désigné par la référence 35, et $\ell/p < \frac{1}{2}$.

Une structure de détecteur selon l'invention, telle que décrite ci-dessus peut être réalisée par croissance de la couche de matériau détecteur, par exemple en CdHgTe, par épitaxie sur le substrat transparent. Pour réaliser le réseau, on forme un masque à la surface de la couche de matériau détecteur obtenue par épitaxie, par exemple dans une couche de résine, et on réalise ensuite le dépôt du matériau constitutif du réseau, par exemple par évaporation. Les techniques de masquage permettent de définir la configuration voulue du réseau (pas constant, ou pas variable).

La formation de microbilles métalliques, et la liaison du détecteur à un circuit de lecture par ces microbilles est décrite dans le document de G.L. Destefanis déjà cité ci-dessus.

Lorsque des contacts sont réalisés par implantation localisée d'ions dans la couche de matériau détecteur, il est possible d'utiliser le même masque pour réaliser les traits du réseau et l'implantation de la zone n du détecteur (dans le cas d'une jonction n/p) ou de la zone p (cas d'une jonction p/n).

Dans tous les cas exposés ci-dessus, il est possible de mettre en oeuvre deux autres variantes, éventuellement en combinaison.

La première variante consiste à introduire dans le dispositif une couche intermédiaire entre le réseau et la couche de matériau détecteur (couche d'adaptation d'impédance). De préférence, une telle couche à une épaisseur de l'ordre d'une fraction de la longueur d'onde λ (par exemple, environ λ/4). Elle peut être en un matériau diélectrique (matériau II-VI ZnS ou ZnSe ; $SiO_2$ ou Ge).

Une couche d'adaptation d'impédance (dont l'indice et l'épaisseur sont choisis de manière à ce qu'elle ait une fonction d'adaptation d'impédance) joue un rôle analogue à celui d'une couche antireflet dans le domaine plus classique des empilements de couches minces pour l'optique.

Plus précisément, cette couche a le rôle d'exacerber le champ électrique de l'onde optique (à détecter) dans le plan de la couche absorbante. En effet, les multiples ondes optiques (issues de l'onde à détecter) sont générées aux interfaces des différents milieux et interfèrent plus ou moins constructivement entre elles. Avec la couche intermédiaire, et notamment en optimisant son épaisseur, entre le réseau et la zone de détection (épaisseur ≈λ/4), on augmente l'amplitude de l'onde au droit de la couche de détecteur, et ainsi on accroît l'efficacité du détecteur.

La deuxième variante consiste à supprimer la couche de substrat 2. Pour cela, on peut réaliser, par exemple, une première étape d'amincissement mécanique (par exemple par rodage mécanique du substrat). Dans une deuxième étape, on réalise un amincissement par des moyens chimiques : on enlève ainsi tout résidu du substrat non enlevé par amincissement mécanique. Pour cela, on immerge le dispositif dans un bain chimique épargnant tous les constituants des circuits, sauf le matériau constitutif du substrat. Ce bain sera également très sélectif sur le matériau constitutif des couches de détection 4, 24, 34, 35. Un tel bain peut être par exemple constitué d'un mélange d'acide fluorhydrique, d'acide nitrique et d'acide acétique, notamment pour un substrat en CdTe.

L'invention a également pour objet un détecteur, ou diode, bispectral. La structure d'un tel détecteur va être décrite en liaison avec la figure 7 (partie A).

Comme précédemment, ce détecteur comporte un substrat transparent 42 destiné à être traversé par le rayonnement 43 à détecter.

Ce détecteur bispectral comporte également, successivement, une première couche 46 de matériau photodétecteur, à gap direct, une couche 48 d'un matériau transparent (par exemple : de longueur d'onde de coupure inférieure à, mais voisine de, nλ), et une deuxième couche 50 d'un matériau photodétecteur (par exemple : de longueur d'onde de coupure inférieure à, mais voisine de, λ), également à gap direct. Sur cette deuxième couche 50 est également formé un réseau 52, à une ou à deux dimensions, à pas constant ou harmonique, ou encore à rapport ℓ/p variable, comme décrit ci-dessus.

Ce dispositif utilise :

- la possibilité qu'a le réseau 52 de diffracter un rayonnement incident à une certaine fréquence, mais également une fréquence harmonique,
- le fait qu'un guide optique dissymétrique, tel que celui présent dans la structure d'un détecteur à réseau selon l'invention, a une longueur d'onde de coupure, c'est-à-dire une longueur d'onde au-delà de laquelle l'onde n'y est plus guidée. Cette longueur d'onde de coupure est principalement fonction de l'épaisseur de la couche détectrice (ce phénomène correspond à l'existence, déjà mentionnée, d'une épaisseur de coupure pour une longueur d'onde donnée).

Par conséquent, en rendant la couche détectrice 50 suffisamment fine, celle-ci ne guidera pas d'onde ayant une longueur d'onde de nλ, mais elle guidera une onde à la longueur d'onde λ. L'épaisseur e de la couche 50 sera donc supérieure à l'épaisseur de coupure à longueur d'onde λ, mais inférieure à l'épaisseur à partir de laquelle elle commence à confiner la longueur d'onde nλ. L'épaisseur e' de la couche 46 sera supérieure à l'épaisseur de coupure à la longueur d'onde nλ. Quant à la couche de matériau transparent 48, son épaisseur doit permettre à la couche de matériau détecteur 46 d'être en résonance avec le réseau 52 pour la longueur d'onde nλ : si cette couche 48 est trop épaisse, le couplage résonnant entre le guide formé par la couche 46 et substrat 42 et le réseau 52 ne se produit plus.

Sur la figure 7 (partie B) sont représentées les répartitions d'intensité des rayonnements aux longueurs d'onde λ et nλ, en fonction de la distance x par rapport au fond du réseau 52.

Dans le cas d'un détecteur bispectral, la couche de substrat transparent 42 peut également être supprimée, par exemple par attaque mécanique puis chimique, comme déjà expliqué ci-dessus dans le cadre d'un précédent mode de réalisation.

Selon un exemple de réalisation, la couche 46 de CdHgTe a une épaisseur de 1 μm, la couche 48 de matériau transparent (CdTe) a une épaisseur de 0,8 μm, la couche 50 de matériau photoconducteur (CdHgTe) a une épaisseur de 0,5 μm. Le réseau 52 présente un pas p=1,8 μm, une profondeur des traits du réseau =0,2 μm Avec une telle structure, la couche 50 détecte un rayonnement à une longueur d'onde $\lambda_0$=5μm, et la couche 46 à une longueur d'onde $\lambda_1$=10μm. Ces deux couches 50 et 46 ont respectivement une longueur d'onde de coupure de 6μm et de 12μm.

Le couplage de chaque couche détectrice 50, 46 peut être réalisé par exemple par l'intermédiaire de connexions électriques directes 56, 60 entre la couche détectrice et un circuit de lecture 70, 66.

## Revendications

1. Dispositif de détection d'un rayonnement électromagnétique comportant :

   - une couche (4, 24, 34) de matériau photodétecteur, à gap direct, comportant une première face et une deuxième face, cette couche formant guide optique,
   - un réseau (6) formé sur une des deux faces de la couche de matériau photodétecteur.

2. Dispositif selon la revendication 1, comportant en outre un substrat (2), transparent à une certaine longueur d'onde, la première face de la couche (4) de matériau photodétecteur étant en contact avec ce substrat, le réseau (6) étant formé sur la deuxième face de la couche de matériau photodétecteur.

3. Dispositif selon l'une des revendications 1 ou 2, une couche intermédiaire étant présente entre le réseau et la couche de matériau photodétecteur, le réseau étant formé au contact de la couche intermédiaire.

4. Dispositif selon la revendication 3, la couche intermédiaire étant une couche d'adaptation d'impédance.

5. Dispositif selon la revendication 4, la couche intermédiaire étant une couche d'un matériau diélectrique.

6. Dispositif selon l'une des revendications 1 à 5, le réseau étant non conducteur.

7. Dispositif selon l'une des revendications 1 à 5, le réseau étant conducteur.

8. Dispositif selon la revendication 7, les traits du réseau étant en contact électrique direct avec la couche de matériau photodétecteur (4).

9. Dispositif selon l'une des revendications 6 à 8, des contacts électriques (10) étant établis entre le réseau (6) et un circuit de lecture (8).

10. Dispositif de détection d'un rayonnement électromagnétique, comportant, dans cet ordre :

    - une première couche (46), d'un premier maté-riau photodétecteur, d'épaisseur $e_1$,
    - une couche intermédiaire (48) d'un matériau transparent à deux longueurs d'onde harmoni-ques $\lambda$ et $n\lambda$,
    - une seconde couche (50), d'un second maté-riau photodétecteur, d'épaisseur $e_2$,
    - un réseau (52) constituant, avec la première couche (46) de premier matériau photodétecteur, une structure résonnante à la longueur d'onde $n\lambda$ et, avec la seconde couche (50) de second matériau photodétecteur et avec la couche intermédiaire (48) de matériau transparent, une structure résonnante à la longueur d'onde $\lambda$.

11. Dispositif selon la revendication 10, comportant en outre un substrat (42) transparent au moins aux deux longueurs d'onde $\lambda$ et $n\lambda$.

12. Dispositif selon la revendication 10 ou 11, chaque couche (46, 50) de matériau photodétecteur étant reliée à un circuit de lecture (66, 70).

13. Dispositif selon l'une quelconque des revendications 1 à 12, le réseau (6, 52) étant un réseau à une dimension.

14. Dispositif selon l'une des revendications 1 à 12, le réseau (6, 52) étant un réseau à deux dimensions.

15. Dispositif selon l'une des revendications précédentes, le réseau comportant une première zone (20) dans laquelle il présente un pas p, et au moins une seconde zone dans laquelle il présente un pas $p' = \frac{p}{2}$.

16. Dispositif selon l'une des revendications 1 à 14, le réseau comportant au moins une zone dans laquel-le le rapport $\ell/p$ est fixe.

17. Dispositif selon l'une des revendications 1 à 14, le réseau comportant au moins une zone (30) dans laquelle le rapport $\ell/p$ est variable, où $\ell$ représente la largeur des traits du réseau et p le pas du réseau.

18. Dispositif selon la revendication 17, le pas du réseau évoluant de manière périodique dans la zone dans laquelle le pas est variable.

FIG.1

EP 0 807 982 A1

FIG. 4

FIG. 5

FIG. 6

FIG. 7

Office européen
des brevets

**RAPPORT DE RECHERCHE EUROPEENNE**

Numero de la demande

EP 97 40 1054

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X | YEONG-CHENG WANG ET AL: "A NUMERICAL ANALYSIS OF THE DOUBLE PERIODIC REFLECTION METAL GRATING FOR MULTIQUANTUM WELL INFRARED PHOTODETECTORS" JOURNAL OF APPLIED PHYSICS, vol. 74, no. 4, 15 août 1993, pages 2192-2196, XP000393932 * figure 1 * | 1,2,7,8, 10,11,14 | H01L31/0232 H01L31/09 |
| A | SARUSI G ET AL: "IMPROVED PERFORMANCE OF QUANTUM WELL INFRARED PHOTODETECTORS USING RANDOM SCATTERING OPTICAL COUPLING" APPLIED PHYSICS LETTERS, vol. 64, no. 8, 21 février 1994, pages 960-962, XP000425903 * figure 1A * | 1,10,13, 14 | |
| A | FR 2 589 591 A (COMMISSARIAT ENERGIE ATOMIQUE) 7 mai 1987 * revendications * | 1,10 | |
| A | US 5 479 018 A (MCKEE RICHARD C ET AL) 26 décembre 1995 * figures 3,4 * | 1,10 | DOMAINES TECHNIQUES RECHERCHES (Int.Cl.6) H01L |
| A | EP 0 585 094 A (SHARP KK) 2 mars 1994 * le document en entier * | 1,10 | |
| A,D | DESTEFANIS G L: "HGCDTE INFRARED DIODE ARRAYS" SEMICONDUCTOR SCIENCE AND TECHNOLOGY, vol. 6, no. 12C, 1 décembre 1991, pages C88-C92, XP000247934 * le document en entier * | 10,12 | |

Le présent rapport a été établi pour toutes les revendications

| Lieu de la recherche | Date d'achèvement de la recherche | Examinateur |
|---|---|---|
| LA HAYE | 25 août 1997 | Lina, F |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)